# EUROPEAN PATENT SPECIFICATION

(11) **EP 0 735 634 B1**
(45) Date of publication and mention of the grant of the patent: **05.07.2000**
(21) Application number: 96201431.2
(22) Date of filing: 30.11.1990
(51) Int. Cl.: H01S 3/03, H03K 3/57, H03K 17/10, H03K 17/12

(54) **Pulse generator circuit**
Impulsgeneratorschaltung
Circuit générateur d'impulsions

(30) Priority: 31.01.1990 JP 2068090
(43) Date of publication of application: 02.10.1996
(62) Divisional of application: 90313030.0
(73) Proprietor: MITSUBISHI DENKI KABUSHIKI KAISHA, Chiyoda-ku Tokyo-to, 100 (JP)
(72) Inventor: Itou, Hiroshi, Chuou Kenkyusho, Mitsubishi D. K.K., Amagasaki-shi, 661 (JP); Iwata, Akihiko, c/o Chuou Kenkyusho, Amagasaki-shi, 661 (JP); Okamoto, Tatsuki, c/o Chuou Kenkyusho, Amagasaki-shi, 661 (JP); Ueda, Yoshihiro, c/o Chuou Kenkyusho, Amagasaki-shi, 661 (JP); Tabata, Yoichiro, c/o Chuou Kenkyusho, Amagasaki-shi, 661 (JP); Murata, Shinji, c/o Seisan-Gijutsu Kenkyusho, Amagasaki-shi, 661 (JP); Kumagai, Takashi, c/o Seisan-Gijutsu Kenkyusho, Amagasaki-shi, 661 (JP)
(74) Representative: Beresford, Keith Denis Lewis

(56) References cited:
- EP-A- 0 351 144
- US-A- 3 651 341

## Description

The present invention relates to a pulse generator circuit, particularly a pulse generator circuit including a semi-conductor switching apparatus for switching high-voltage and large-current, such as those used for energising a pulsed laser.

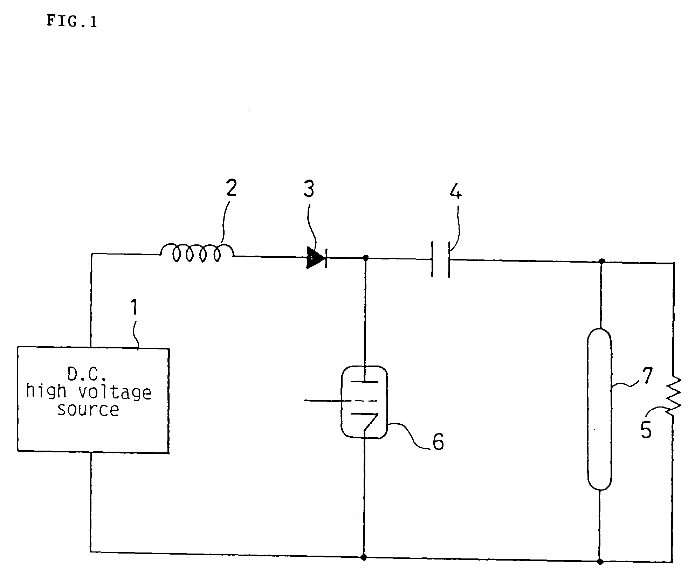

Fig. 1 is a circuit diagram showing a conventional pulse generator circuit for a copper vapour laser which is disclosed, for example, in "COPPER VAPOR LASERS COME OF AGE" of LASER FOCUS (July, 1982).

In Fig. 1, a D.C. high voltage source 1 generates a D.C. high voltage (from several kilovolts to tens of kilovolts). A capacitor 4 is thereby charged with current through a reactor 2, a diode 3 and a resistor 5. Thereafter, when a Thyratron switch 6 turns on, electric charge stored in the capacitor 4 is supplied to a laser tube (discharge tube) 7 through the thyratron switch 6. Discharge is thereby initiated in the laser tube 7, and a metal such as copper included in the laser tube 7 is heated and vaporized. At that time, since the impedance of the laser tube 7 is made very much smaller than the resistance of the resistor 5, current flows mainly through the laser tube 7. The laser tube 7 is thereby excited and generates laser oscillation.

In the above-mentioned pulse generator circuit, it is necessary to impress the laser tube 7 with a very sharp-shaped pulse voltage in order to obtain a laser output as high as possible. Accordingly, the thyratron switch 6 is required to have a very fast and large power switching ability of tens of nanoseconds to turn itself on from off.

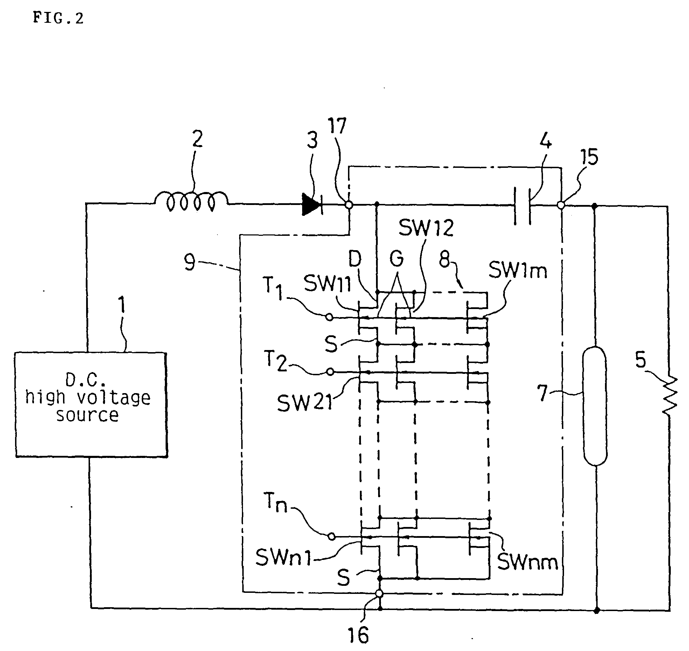

The above-mentioned thyratron switch 6 is a vacuum tube device and so its lifetime is comparatively short. It is therefore often necessary to exchange the thyratron switch 6. Furthermore, since the thyratron switch 6 is handmade, each has individual characteristics in rise-up of current and in a switching time, which affects the efficiency of laser. Therefore, when the thyratron switch 6 is exchanged for a new one, the above-mentioned characteristics are changed as a result. Figure 2 shows a circuit in which a synthetic semiconductor switch 8 is used instead of a thyratron switch 6.

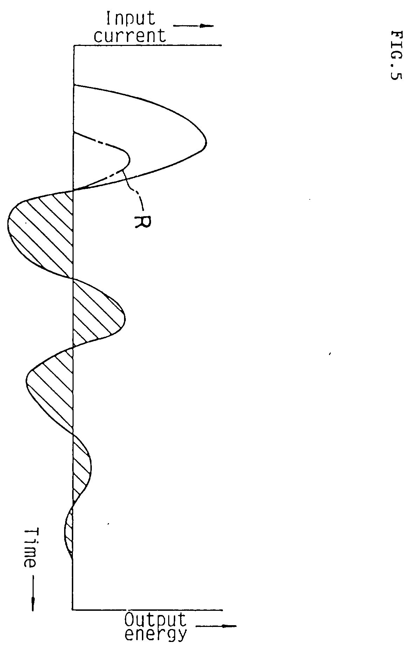

In Fig. 2, when the synthetic semiconductor switch 8 turns on, electric charge stored in the capacitor 4 is supplied to the laser tube 7. At that time, according to the present impedance of the laser tube 7, electric ringing may occur in a discharge pulse circuit including the synthetic semiconductor switch 8, the capacitor 4 and the laser tube 7. By this ringing, ringing current shown by a solid curve in fig. 5 flows in the laser tube 7.

However, the laser light is issued with only a wave R shown by a chain line, the ringing current after issue of the laser light, which is shown by the hatch, does not contribute any more to the laser light oscillation. On the contrary, the ringing current shown by the hatch gives the laser tube 7 an excessive input energy which increases a number of atoms of lower level and results in lowering of efficiency of the laser light oscillation.

The present invention, which is defined in the appended claims, is intended to avoid the above-mentioned lowering of efficiency.

While the novel features of the invention are set forth particularly in the appended claims, the invention, both as to organisation and content, will be better understood and appreciated, along with other objects and features thereof, from the following detailed description taken in conjunction with the accompanying drawings of which:
Fig. 1 is a circuit diagram showing a conventional pulse generator circuit;
Fig. 2 is a circuit diagram showing a first example of a pulse generator circuit including a semiconductor switching apparatus;
Fig. 3 is a front view showing a semiconductor switching apparatus;
Fig. 4 is a cross-sectional side view taken on line II-II in Fig. 3;
Fig. 5 is a graph showing a waveform of a ringing current and an output waveform of a laser light;
Fig. 6 is a circuit diagram showing a second example of a pulse generator circuit;
Fig. 7 is a graph showing a waveform of a rectified ringing current and the output waveform of the laser light;
Fig. 8 is a circuit diagram showing the pulse generator circuit of a first embodiment of the present invention;
Fig. 9(a), Fig. 9(b) and Fig. 9(c) are graphs showing waveforms of a current Iₓ, a voltage V_{d} and a voltage V_{b} in Fig. 8, respectively; and
Fig. 10 is a circuit diagram showing a second embodiment of the present invention.

It will be recognised that some or all of the figures are schematic representations for purposes of illustration and do not necessarily depict the actual relative sizes or locations of the elements shown.

The description of preferred embodiments will be preceded by a description of first and second comparative examples of pulse generator circuits.

Fig. 2 is a circuit diagram showing a pulse generator circuit including a semiconductor switching apparatus 9. In Fig. 2, the semiconductor switching apparatus 9 consists of a synthetic semiconductor switch 8 (described later), as switching means, and a capacitor 4 and has three terminals 15, 16 and 17. A reactor 2 and a diode 3 are connected to a positive end of a D.C. high voltage source 1, and the terminal 17 of the semiconductor switching apparatus 9 is connected to a cathode of the diode 3. The terminal 16 of the semiconductor switching apparatus 9 is connected to a negative end of the D.C. high voltage source 1. A load device, in particular a laser tube (discharge tube) 7, to which a resistor 5 is connected in parallel, is connected between two terminals 15 and 16 of the semiconductor switching apparatus 9.

The D.C. high voltage source 1 generates a D.C. high voltage (from several kilovolt to tens of kilovolts). The capacitor 4 is thereby charged with current through the reactor 2, the diode 3 and the resistor 5. After that, when the synthetic semiconductor switch 8 turns on, electric charge stored in the capacitor 4 is supplied to the laser tube 7 through the synthetic semiconductor switch 8. Discharge is thereby initiated in the laser tube 7, and a metal, such as copper, included in the laser tube 7, is heated and vaporised. At that time, since the impedance of the laser tube 7 becomes very much smaller than the resistance of the resistor 5, current flows mainly through the laser tube 7. The laser tube 7 is thereby excited and generates laser oscillation.

The above-mentioned synthetic semiconductor switch 8 consists of plural semiconductor switches SW11, ---, SWnm which are connected in series and parallel with one another. In this embodiment, an FET (Field Effect Transistor) is employed for each of the semiconductor switches. In Fig. 2, n FETs SW11 --- SWn1 (n:integer) are connected in series with one another in a manner that each drain terminal is connected to a source terminal of an adjacent FET. Further, m FETs SW11 --- SW1m (m: integer) are connected in parallel with one another. In a similar way, each respective m FETs SW21 --- SW2m, ---, SWn1 --- SWnm are connected in parallel with one another. As a result, m x n FETs SW11, ---, SWnm are connected in series and parallel with one another, thereby forming a connection of grid pattern. Gate terminals G of each group of m FETs SW11 --- SW1m, ---, SWn1 --- SWnm are connected to terminals T1, --- Tn, respectively.

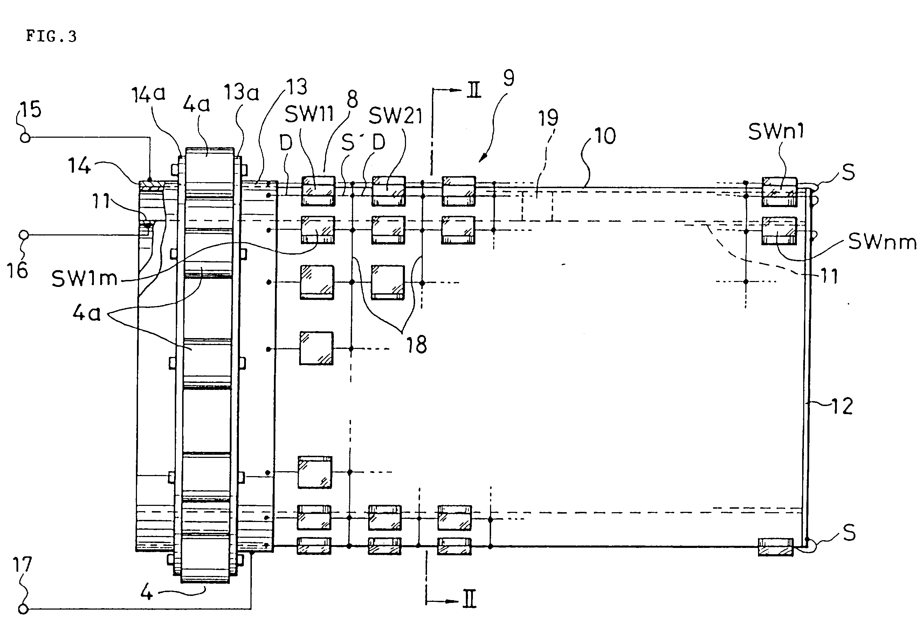

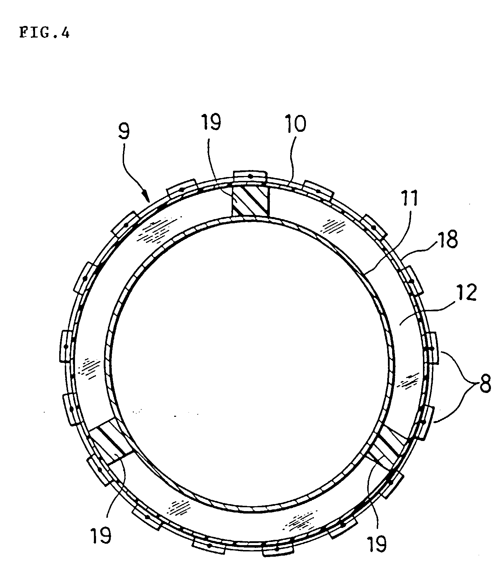

Next, construction of the semiconductor switching apparatus 9 is described. Fig. 3 is a front view showing the semiconductor switching apparatus 9, and Fig. 4 is a side view of the semiconductor switching apparatus 9 taken on line II-II in Fig. 3.

In Fig. 3 or Fig. 4, a cylindrical outer tube (a first tube) 10 is of insulating material, such as ceramic. A cylindrical inner tube (a second tube) 11, which is of conductive material, is provided in coaxial alignment with the outer tube 10 via spacers 19. The right end of the outer tube 10 and the right end of the inner tube 11 are electrically connected to each other via an annular short-circuit ring 12 of conductive material. A pair of support rings 13 and 14, of conductive material such as copper, are fitted on and around the outer tube 10 so that flange portions 13a and 14a of the respective support rings 13 and 14 are disposed to hold and electrically put plural capacitors 4a therebetween. These capacitors 4a are thus connected in parallel with one another, thereby constituting the capacitor 4 of large capacitance as a whole. Potentials generated on the support rings 13, 14 and the inner tube 11 are led to the terminals 17, 15 and 16, respectively.

On the outer surface of the outer tube 1, plural FETs SW11, ---, SWnm are fixed in substantially matrix alignment and electrically connected in series and parallel with one another. Along the axial direction of the outer tube 10, n pieces of the FET SW1m, ---, SWnm are sequentially connected in series with adjacent one. Each drain terminal D of the left end FET (e.g. SW1m) is connected to the support ring 13, and each source terminal S of the right end FET (e.g. SWnm) is connected to the short-circuit ring 12. Connection points between the respective drain terminals D and the adjacent source terminals S are connected by plural (n-1) lead wires 18 which are provided in the circumferential direction of the outer tube 10. The gate terminals and the wiring therefor are omitted in FIGs.3 and 4 for simplicity and clarity of illustration.

Hereupon, the reasons for employing the above-mentioned synthetic semiconductor switch 8 are described. The semiconductor switch such as FET has generally a semi-permanent lifetime and is stable in operation. However, there has not been developed hitherto a semiconductor device which can realize the switching at a voltage range from several kilovolts to tens of kilovolts within tens of nanoseconds. It is therefore impossible to replace the conventional thyratron switch with a single semiconductor switch. The FET, which is capable of switching in tens of nanoseconds, has a withstand voltage of at most about 1 kilovolt. In order to realize the withstand voltage of several to tens kilovolts by the FET, it is necessary to connect plural FETs in series with one another. Furthermore, since current capacity of one FET is comparatively small, it is also necessary to make each of the series-connected FETs into plural FETs which are connected in parallel with one another. As a result, plural FETs SW11 -- SWnm are aligned in the matrix pattern and are connected in series and parallel with one another to form the grid-pattern connection.

In general, it is difficult to get a balanced current distribution among the plural FETs connected in parallel with one another. However, in such a very short switching time (e.g. tens of nanoseconds) as required for the copper vapor laser unit, distribution of current is determined by counter-electromotive force of each inductance induced by geometrical configuration of the semiconductor switching apparatus 9 rather than by ON-state voltage based on inherent characteristics of the FET. This is because the inductance is very much larger than a resistance of each FET in the ON-state because of a very high frequency component contained in the very short pulse.

In the above-mentioned apparatus, the outer tube 10 on which plural FETs SW11, ---, SWnm connected in series and parallel with one another are provided, and the inner tube 11 are disposed in coaxial alignment. Further, the inner tube 11 acts as a common return line for the plural FETs SW11, ---, SWnm. Therefore, inductances seen from the respective FETs SW11, ---, SWnm are substantially equal to one another. As a result, the current equally branches out into the FETs connected in parallel with one another, thereby realizing an excellent switching characteristics as a whole.

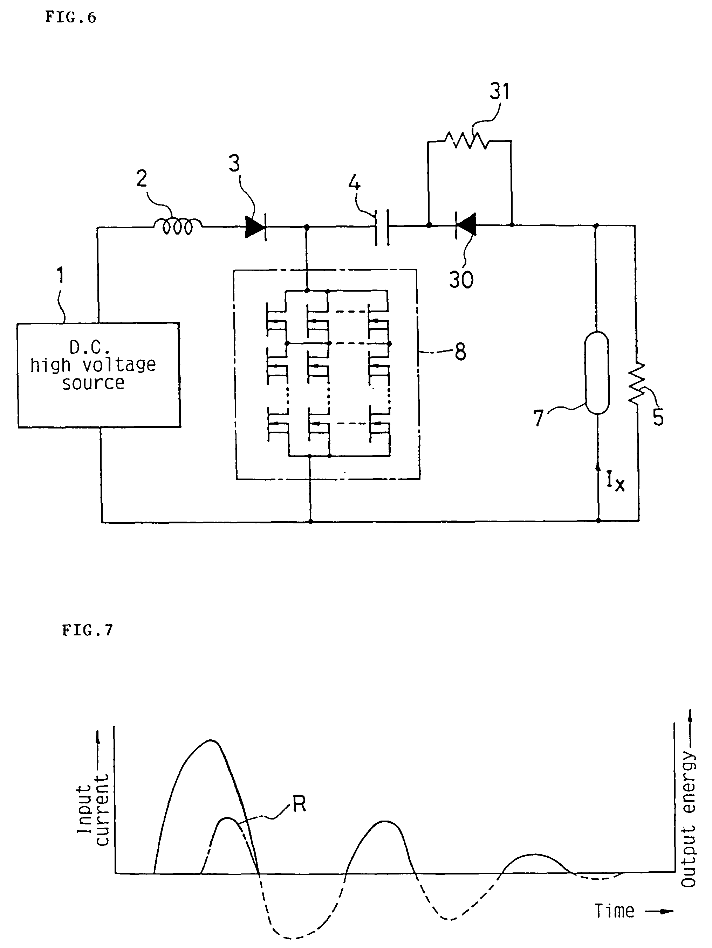

Fig. 6 is a circuit diagram showing a second example of pulsed generator circuit. Corresponding parts and components to the first example (Fig.2) are shown by the same numerals and marks, and the description thereon made in the first example similarly applies. Differences and features of this second example from the first example are as follows.

In this example, a diode 30 and a bypass resistor 31 connected in parallel thereto are provided in addition to the pulse generator circuit shown in fig. 2.

The capacitor 4 is charged with current by the D.C. high voltage source 1 through the reactor 2, the diode 3, the bypass resistor 31 and the resistor 5. When the synthetic semiconductor switch 8 turns on, electric charge stored in the capacitor 4 is supplied to the laser tube 7 through the synthetic semiconductor switch 8 and the diode 30. The laser tube 7 is thereby excited and generates laser oscillation. Even after completion of the laser oscillation, the ringing current shown by a solid and dotted curve in Fig. 7 is still alive in a closed circuit including the laser tube 7. However, negative current (shown by the dotted curve) of the subsequent ringing current is shut off by the diode 30. Input of the unnecessary and excessive ringing current to the laser tube 7 is thereby prevented, and also the efficiency of the laser light oscillation is improved.

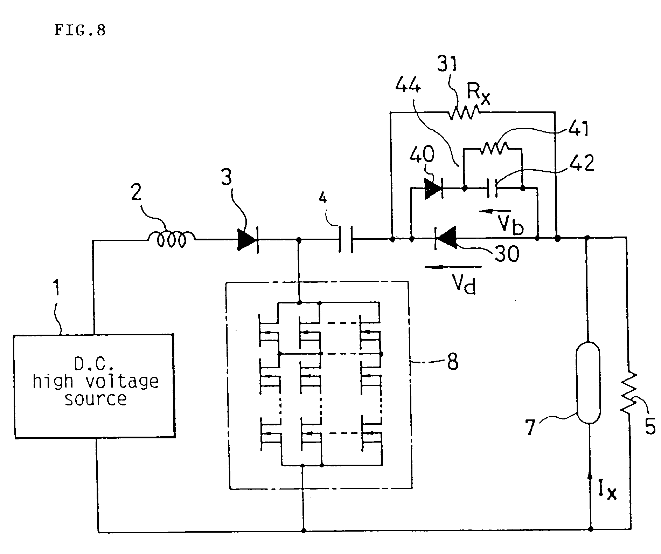

Fig. 8 is a circuit diagram showing the pulse generator circuit of a first embodiment. Corresponding parts and components to the second example (Fig. 6) are shown by the same numerals and marks, and the description thereon made in the second example similarly applies. Differences and features of this first embodiment from the second example are as follows. In this embodiment, a snubber circuit 44 is provided in addition to the circuit shown by Fig. 6. A capacitor 42 and a diode 40 are connected in series with each other and connected in parallel with the diode 30. A resistor 41 is connected in parallel with the capacitor 42.

When the diode 30 acts to inhibit the reverse current, an excessive voltage responding to di/dt is applied across a cathode and an anode of the diode 30. This excessive voltage may cause dielectric breakdown of the diode. However, a snubber circuit 44 consisting of the capacitor 42 and the diode 40 and the resistor 41 serves to protect the diode 30 from the excessive voltage as described in the following.

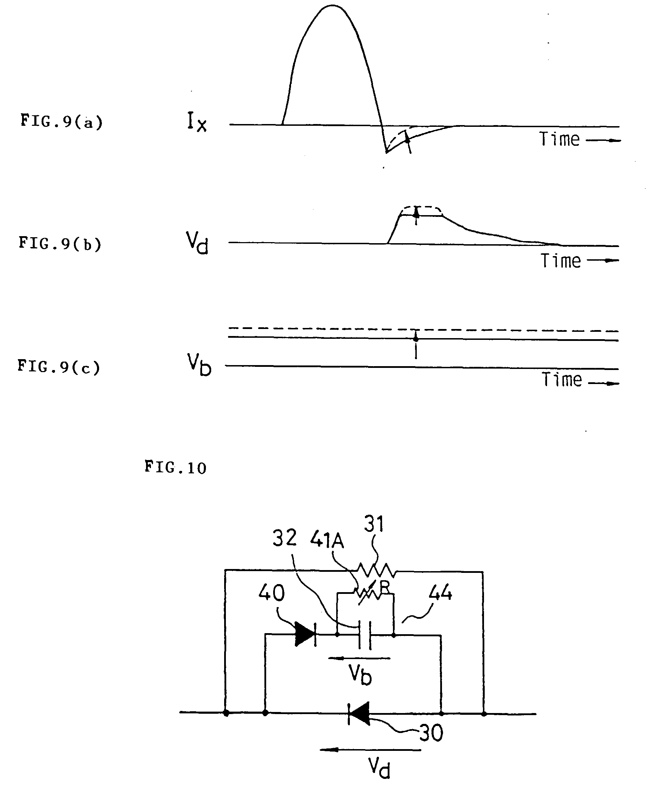

When the synthetic semiconductor switch 8 turns on, a current Iₓ shown by Fig. 9(a) flows in the laser tube 7. Immediately after oscillation of the laser, a negative voltage V_{d} (Fig. 9(b)) is instantaneously applied across the ends of the diode 30. However, this voltage is reduced to a voltage V_{b} (Fig. 9(c)) by means of the snubber circuit 44, thereby lowering the excessive voltage applied across the diode 30. As a result, dielectric breakdown of the diode 30 is prevented. The voltage V_{d} lowers in accordance with a time constant which is defined by a capacitance of the capacitor 42 and a resistance of the resistor 41.

In a second embodiment a variable resistor 41A is employed in place of the fixed resistor 41. This is shown in Fig. 10. In this embodiment the reverse current after oscillation of the laser can be set to be a predetermined level by adjusting the variable resistor 41A. The reverse current adjusted properly is utilised to heat the laser tube 7, for instance, at the time when the laser tube is still cold. That is, by adjusting the excessive current flowing in the laser tube 7, optimum waveform of current can be applied to the laser tube 7. When a resistance of the resistor 41A is increased, waveforms of the current I_{X}, the voltage V_{d} and the voltage V_{b} are shifted toward directions shown by arrows in Figs. 9(a), 9(b) and 9(c), thereby resulting in dotted lines, respectively.

Although the invention has been described in its preferred form with a certain degree of particularity, it is understood that the present disclosure of the preferred form may be changed in the details of construction and that modifications may be made within the scope of the invention as defined in the appended claims.

## Claims

1. A pulse generator circuit comprising:
a high voltage capacitor (4);
a semiconductor switching means (8);
a first diode (30) connected in series with said high voltage capacitor (4) and said semiconductor switching means (8) in order to form a loop when said pulse generator circuit is connected across a load (5,7), which first diode (30) is to suppress electric ringing when said high voltage capacitor (4) is discharged across the load (5,7); and
a snubber circuit (40-42) connected across said first diode (30), said snubber circuit (40-42) comprising a second diode (40) with an opposite polarity to that of said first diode (30) and a second capacitor (42) in series with said second diode, and a first resistor (41) in parallel with said second capacitor (42).

2. A pulse generator circuit according to claim 1 including a second resistor (31) connected in parallel with said first diode (30).

3. A pulse generator circuit according to either of claims 1 or 2 wherein said first resistor (41) is a variable resistor.

4. A pulse generator circuit according to any preceding claim together with the load (5,7) which is connected in series therewith to form a loop.

5. A pulse generator circuit and load according to claim 4 wherein said load (5,7) is a laser (7) and a resistor (5) connected in parallel with said laser (7).

6. A pulse generator circuit according to any of claims 1 to 3 or a pulse generator circuit and load according to either of claims 4 or 5, together with a D.C. high voltage source (1) in series with a reactor (2) and a diode (3) of polarity the opposite to that of said first diode (30), which series connected source (1), reactor (2) and diode (3) are connected across said semiconductor switching means (8).

## Patentansprüche

1. Impulsgeneratorschaltung, die folgendes aufweist:
einen Hochspannungskondensator (4);
eine Halbleiter-Schalteinrichtung (8);
eine erste Diode (30), die mit dem Hochspannungskondensator (4) und der Halbleiter-Schalteinrichtung (8) in Reihe geschaltet ist, um eine Schleife zu bilden, wenn die Impulsgeneratorschaltung parallel zu einer Last (5, 7) geschaltet ist, wobei die erste Diode (30) zum Unterdrücken von elektrischem Überschwingen dient, wenn der Hochspannungskondensator (4) über die Last (5, 7) entladen wird; und
eine Begrenzungsschaltung (40 - 42), die parallel zu der ersten Diode (30) geschaltet ist, wobei die Begrenzungsschaltung (40 - 42) eine zweite Diode (40) mit entgegengesetzter Polarität zu der der ersten Diode (30) und einen zweiten Kondensator (42) in Reihe mit der ersten Diode sowie einen ersten Widerstand (41) parallel zu dem zweiten Kondensator (42) aufweist.

2. Impulsgeneratorschaltung nach Anspruch 1,
mit einem zweiten Widerstand (31), der zu der ersten Diode (30) parallel geschaltet ist.

3. Impulsgeneratorschaltung nach Anspruch 1 oder 2,
wobei es sich bei dem ersten Widerstand (41) um einen variablen Widerstand handelt.

4. Impulsgeneratorschaltung nach einem der vorausgehenden Ansprüche zusammen mit der Last (5, 7), die mit der Impulsgeneratorschaltung in Reihe geschaltet ist, um eine Schleife zu bilden.

5. Impulsgeneratorschaltung und Last nach Anspruch 4, wobei die Last (5, 7) von einem Laser (7) und einem Widerstand (5) gebildet ist, der zu dem Laser (7) parallel geschaltet ist.

6. Impulsgeneratorschaltung nach einem der Ansprüche 1 bis 3 oder Impulsgeneratorschaltung und Last nach Anspruch 4 oder 5, zusammen mit einer Gleichstrom-Hochspannungsquelle (1) in Reihe mit einer Drossel (2) und einer Diode (3) mit entgegengesetzter Polarität zu der der ersten Diode (30), wobei die Reihenschaltung aus der Quelle (1), der Drossel (2) und der Diode (3) parallel zu der Halbleiter-Schalteinrichtung (8) geschaltet ist.

## Revendications

1. Circuit générateur d'impulsions comprenant :
un condensateur à haute tension (4);
un moyen de commutation (8) à semi-conducteur;
une première diode (30) reliée en série audit condensateur à haute tension (4) et audit moyen de commutation (8) à semi-conducteur dans le but de former une boucle lorsque ledit circuit générateur d'impulsions est relié aux bornes d'une charge (5, 7), laquelle première diode (30) est destinée à supprimer l'oscillation électrique lorsque ledit condensateur à haute tension (4) est déchargé entre les bornes de la charge (5, 7); et
un circuit amortisseur (40 à 42) relié aux bornes de ladite première diode (30), ledit circuit amortisseur (40 à 42) comprenant une seconde diode (40) présentant une polarité opposée à celle de ladite première diode (30), et un second condensateur (42) en série avec ladite seconde diode, et une première résistance (41) en parallèle avec ledit second condensateur (42).

2. Circuit générateur d'impulsions selon la revendication 1, comprenant une seconde résistance (31) reliée en parallèle à ladite première diode (30).

3. Circuit générateur d'impulsions selon l'une des revendications 1 ou 2, dans lequel ladite première résistance (41) est une résistance variable.

4. Circuit générateur d'impulsions selon l'une quelconque des revendications précédentes, assemblé avec la charge (5, 7) qui est reliée en série à celui-ci afin de former une boucle.

5. Circuit générateur d'impulsions et charge selon la revendication 4, dans lequel ladite charge (5, 7) est constituée par un laser (7) et une résistance (5) reliée en parallèle audit laser (7).

6. Circuit générateur d'impulsions selon l'une quelconque des revendications 1 à 3 ou circuit générateur d'impulsions et charge selon l'une des revendications 4 ou 5, assemblé à une source à haute tension continue (1) en série avec une bobine (2) et une diode (3) de polarité opposée à celle de ladite première diode (30), lesquelles source (1), bobine (2) et diode (3) reliées en série sont reliées à travers ledit moyen de commutation à semi-conducteur (8).
